# EUROPEAN PATENT APPLICATION

(11) **EP 2 693 507 A1**
(43) Date of publication of application: **05.02.2014**
(21) Application number: 11862431.1
(22) Date of filing: 30.03.2011
(51) Int. Cl.: H01L 51/50, H01L 51/52, H01L 51/54, H01L 51/56

(54) **FLEXIBLE ORGANIC ELECTROLUMINESCENT DEVICE AND MANUFACTURING METHOD THEREOF**

(71) Applicant: Ocean's King Lighting Science & Technology Co., Ltd., Nanhai Rd., Nanshan Shenzhen, Guangdong 518054 (CN)
(72) Inventor: ZHOU, Mingjie, Shenzhen Guangdong 518054 (CN); WANG, Ping, Shenzhen Guangdong 518054 (CN); FENG, Xiaoming, Shenzhen Guangdong 518054 (CN); HUANG, Hui, Shenzhen Guangdong 518054 (CN)
(74) Representative: Johnson, Richard Alan
(86) International application number: PCT/CN2011/072301
(87) International publication number: WO 2012/129791

(57) **Abstract**

A flexible organic electroluminescent device and a manufacturing method thereof are provided. The device comprises a substrate (101), an anode layer (103), a hole-injecting layer (104), a hole-transporting layer (105), a light-emitting layer (106), an electron-transporting layer (107), an electron-injecting layer (108), and a cathode layer (109), which are stacked in order. The device further comprises a buffer layer (102) between the substrate (101) and the anode layer (103). The anode layer (103) is a multilayer composite structure, which comprises ZnS/Ag/MoO₃. The bonding force between the anode layer (103) and the substrate (101) is enhanced by inserting buffer layer (102). The device has a good bending endurance performance, a stable luminous property and a high light emitting efficiency.

## Description

### FIELD OF THE INVENTION

The present invention relates to the field of optoelectronic devices, and particularly relates to a flexible organic electroluminescent device. The present invention also relates to a method for manufacturing the flexible organic electroluminescent device.

### BACKGROUND OF THE INVENTION

Organic electroluminescent device (Organic Light Emission Diode), hereinafter referred to as OLED, has characteristics such as high luminance, wide selection of material, low driving voltage and solid-state self-luminosity, as well as advantages such as high definition, wide viewing angle and fast response, which makes it not only conform to the development trends of mobile communication and information display in the information age, but also meet the requirements of green lighting technology. OLED is the primary focus of many domestic and overseas researchers.

The prior art OLED device provided with glass substrate does not have a curved features and the glass is fragile , thus impacting on the application of OLED. The OLED device using flexible material as substrate has advantages of thinner and more impact-resistant over OLED device having glass substrate. Also, flexible OLED can be manufactured by roll-to-roll method, thereby significantly reducing the manufacturing cost. Currently, the flexible substrates for display are mainly ultra-thin glass, polymer film, foil, etc.

Usually, the anode using polymer film as substrate is manufactured by sputtering technique to cover a transparent conductive thin film, ITO or IZO for instance, on its surface. However, there are many insurmountable problems existing in application of such conductive thin films in flexible OLED. For example, in the process of manufacturing ITO thin film, the doping proportion of various elements, such as indium (In) and stannum (Sn), is difficult to control, resulting in uncontrollable morphology of ITO, carrier and transmission performance. Therefore, performance of light-emitting device is unstable. Secondly, when conductive thin film such as ITO is manufactured on flexible substrate, due to the poor heat resistance of the polymer thin film, low-temperature sputtering technique is usually adopted to prepare conductive thin film. The conductive thin film as prepared has high surface resistance, weak bonding force between the thin film and the substrate, so that the conductive thin film is prone to fall off the substrate in the process of repeated bending, thus affecting the stability of the OLED device.

### SUMMARY OF THE INVENTION

The purpose of the present invention is to provide a flexible organic electroluminescent device having a good bending endurance performance, a stable luminous property and a high light emitting efficiency.

The technical solution of the present invention is:

A flexible organic electroluminescent device, having layered structure as follows: substrate / anode layer / hole-injecting layer / hole-transporting layer / light-emitting layer / electron-transporting layer / electron-injecting layer / cathode layer; wherein a buffer layer between said substrate and anode layer is also prepared; said anode has a multilayer composite structure as follows: ZnS/Ag/MoO₃.

In the flexible organic electroluminescent device of the present invention, the material of substrate includes polyethylene terephthalate (PET), polyether sulfone (PES), polyethylene naphthalate (PEN), transparent polyimide (PI), clyclic olefin copolymer (COC), polycarbonate (PC), polyethylene (PE), and other material; the selected material has a visible light transmittance greater than 80%, and the thickness is in the range of 0.1 to 0.5mm.

The buffer layer located on the substrate is made of UV glue, and the thickness of the buffer layer can be in the range of 0.5 to 10µm.

The multilayer composite structure of the anode of the flexible organic electroluminescent device provided in the present invention, is all prepared by vapor deposition technique. Specifically, thickness of ZnS layer is selected from 35-80nm, thickness of Ag layer is selected from 18∼30nm. Thickness of MoO₃ layer is selected from 3∼10nm. The multiplayer anode is designed based on the anti-reflection principle of Heat Mirror, therefore the anode layer as prepared has high visible light transmittance and low surface resistance. In order to enhance the hole-injecting performance of anode layer, MoO₃ having hole-injecting ability is used as part of multilayer anode for reducing the barrier of hole-injection.

In the flexible organic electroluminescent device of the present invention, the material of hole-injecting layer is copper phthalocyanine (CuPc) or 4,4',4'-tris(N-3-methylphenyl-N-phenyl-amino)-triphenylamine (m-MTDATA), thickness of the hole-injecting layer is in the range of 30 to 40nm;

the material of said hole-transporting layer is phenylmorpholine (NPB), N,N'-bis(3-methylphenyl)-N,N'-diphenyl-4,4'-benzidine (TPD) or 1,3,5-triphenylbenzene (TDAPB), the thickness of said hole-transporting layer is in the range of 30 to 80nm;

the material of said light-emitting layer is 4,4'-bis(N-carbazolyl)-1,1'-biphenyl doped with tris(2-phenylpyridine)iridium (i.e. Ir(ppy)₃:CBP), DCJTB:Alq₃ or α-NPD:Ir(MDQ)₂(acac), the thickness of said light-emitting layer is in the range of 15 to 40nm;

the material of said electron-transporting layer is 4,7-diphenyl-1,10-phenanthroline (Bphen), tris(8-hydroxyquinolinato)aluminium (Alq₃), 2-(4-tert-butylphenyl)-5-(4-biphenyl)-1,3,4-oxadiazole (PBD), 1,2,4-triazole derivatives (e.g. TAZ) or N-phenyl benzimidazole (TPBi), the thickness of said electron-transporting layer is in the range of 20 to 60nm;

the material of said electron-injecting layer is preferably lithium fluoride (LiF), cesium fluoride (CsF) or 8-hydroxyquinolinato lithium (Liq), the thickness of said electron-injecting layer is in the range of 0.5 to 2nm; the material of said cathode layer is preferably Al, Ag or Mg-Ag alloy layer, the thickness of said cathode layer is in the range of 100 to 200nm.

The present invention also provides a method for manufacturing flexible organic electroluminescent device, which comprises the following steps:

1. placing substrate (i.e. polymer film) into deionized water containing detergent for ultrasonic cleaning, washing with deionized water, after that, ultrasonically treating successively with isopropanol and acetone, then blow drying with nitrogen for later use;

2. placing the cleaned polymer film on a spin coater, spin-coating UV glue on the surface of polymer film, then curing using a UV lamp or ultraviolet lamp to form a buffer layer; wherein the rotate-speed of spin coater is in the range of 1000 to 5000r/min, time of spin coating is in the range of 30 to 120s.

3. Vapor depositing successively ZnS layer, Ag layer, MoO₃ layer by using vacuum coating method to obtain an anode layer having multilayer composite structure of ZnS/Ag/MoO₃.

4. Depositing successively hole-injecting layer, hole-transporting layer, light-emitting layer, electron-transporting layer, electron-injecting layer and cathode layer on anode layer by using vacuum coating method, finally obtaining flexible organic electroluminescent device.

By adopting vacuum coating technology, ZnS/Ag/MoO₃ multilayer composite structure is prepared as anode layer, and its manufacturing method is simple, less destructive to the substrate. In addition, the anode layer has good transmission of light and low surface resistance. Moreover, the bonding force between the anode layer and the substrate is enhanced by inserting buffer layer, so that the prepared flexible organic electroluminescent device has a good bending endurance performance, a stable luminous property and a high light emitting efficiency.

### BRIEF DESCRIPTION OF THE DRAWINGS

Fig. 1 is a schematic structural view of the flexible organic electroluminescent device of the present invention; wherein,
   101 substrate, 102 buffer layer, 103 anode layer, 104 hole-injecting layer, 105 hole-transporting layer, 106 light-emitting layer, 107 electron-transporting layer, 108 electron-injecting layer, 109 cathode layer;
Fig. 2 is a flow diagram showing the preparation of flexible organic electroluminescent device of the present invention;
Fig. 3 shows transmittance curves of anode layer ZnS/Ag/MoO₃ of Example 2 and anode layer ITO of Comparative Example 1.
Fig. 4 shows the luminance and initial luminance comparison between the electroluminescent devices manufactured in Example 2 and Comparative Example 1 after repeated bending;
Fig. 5 shows current-voltage curves of the electroluminescent devices manufactured in Example 2 and Comparative Example 1.

### DETAILED DESCRIPTION OF ILLUSTRATED EMBODIMENTS

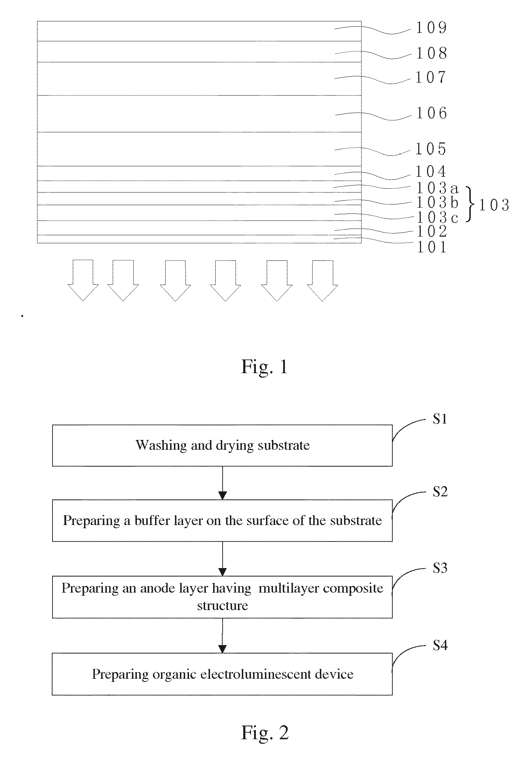

As shown in Fig. 1, the flexible organic electroluminescent device of the present invention has layered structure as follows: substrate 101/ buffer layer 102/ anode layer 103/ hole-injecting layer 104/ hole-transporting layer 105/ light-emitting layer 106/ electron-transporting layer 107/ electron-injecting layer 108/ cathode layer 109; wherein, anode layer has a multilayer composite structure as follows: ZnS 103a/Ag 103b/MoO₃ 103c.

In the organic electroluminescent device of the present invention, the material of substrate includes polyethylene terephthalate (PET), polyether sulfone (PES), polyethylene naphthalate (PEN), transparent polyimide (PI), clyclic olefin copolymer (COC), polycarbonate (PC), polyethylene (PE), and other material; the selected material has a visible light transmittance greater than 80%, and the thickness is in the range of 0.1 to 0.5mm.

The buffer layer located on the substrate is made of UV glue, and thickness of the buffer layer can be in the range of 0.5 to 10µm.

The multilayer composite structure of the anode of the flexible organic electroluminescent device provided in the present invention, is all prepared by vapor deposition technique. Specifically, thickness of ZnS layer is selected from 35-80nm, Ag layer is selected from 18∼30nm.thickness of MoO₃ layer is selected from 3∼10nm.The multiplayer anode is designed based on the anti-reflection principle of Heat Mirror, therefore the anode layer as prepared has high visible light transmittance and low surface resistance. In order to enhance the hole-injecting performance of anode layer, MoO₃ having hole-injecting ability is used as part of multilayer anode for reducing the hole-injection barrier.

Various functional layers of the flexible organic electroluminescent device of the present invention, such as:

the material of hole-injecting layer is copper phthalocyanine (CuPc) or 4,4',4'-tris(N-3-methylphenyl-N-phenyl-amino)-triphenylamine (m-MTDATA), thickness of the hole-injecting layer is in the range of 30 to 40nm;

the material of said hole-transporting layer is phenylmorpholine (NPB), N,N'-bis(3-methylphenyl)-N,N'-diphenyl-4,4'-benzidine (TPD) or 1,3,5-triphenylbenzene (TDAPB), the thickness of said hole-transporting layer is in the range of 30 to 80nm;

the material of said light-emitting layer is 4,4'-bis(N-carbazolyl)-1,1'-biphenyl doped with tris(2-phenylpyridine)iridium (i.e. Ir(ppy)3:CBP), DCJTB:Alq₃ or α-NPD:Ir(MDQ)₂(acac), the thickness of said light-emitting layer is in the range of 15 to 40nm;

the material of said electron-transporting layer is 4,7-diphenyl-1,10-phenanthroline (Bphen), tris(8-hydroxyquinolinato)aluminium (Alq₃), 2-(4-tert-butylphenyl)-5-(4-biphenyl)-1,3,4-oxadiazole (PBD), 1,2,4-triazole derivatives (e.g. TAZ) or N-phenyl benzimidazole (TPBi), the thickness of said electron-transporting layer is in the range of 20 to 60nm;

the material of said electron-injecting layer is lithium fluoride (LiF), cesium fluoride (CsF) or 8-hydroxyquinolinato lithium (Liq), the thickness of said electron-injecting layer is in the range of 0.5 to 2nm;

the material of said cathode layer is preferably Al, Ag or Mg-Ag alloy layer, the thickness of said cathode layer is in the range of 100 to 200nm.

The present invention also provides a method for manufacturing flexible organic electroluminescent device, as shown in Fig. 2, which comprises the following steps:

S1. placing substrate (i.e. polymer film) into deionized water containing detergent for ultrasonic cleaning, washing with deionized water, after that, ultrasonically treating successively with isopropanol and acetone, then blow drying with nitrogen for later use;

S2. placing the cleaned polymer film on a spin coater, spin-coating UV glue on the surface of polymer film, then curing using a UV lamp or ultraviolet lamp to form a buffer layer; wherein the rotate-speed of spin coater is in the range of 1000 to 5000r/min, time of spin coating is in the range of 30∼120s.

S3. Vapor depositing successively ZnS layer, Ag layer, MoO₃ layer by using vacuum coating method to obtain an anode layer having multilayer composite structure of ZnS/Ag/MoO₃.

S4. Depositing successively hole-injecting layer, hole-transporting layer, light-emitting layer, electron-transporting layer, electron-injecting layer and cathode layer on anode layer by using vacuum coating method, finally obtaining flexible organic electroluminescent device.

By adopting vacuum coating technology, ZnS/Ag/MoO₃ multilayer composite structure is prepared as anode layer, and its manufacturing method is simple, less destructive for substrate. In addition, the anode layer has good transmission of light and low surface resistance. Moreover, the bonding force between the anode layer and the substrate is enhanced by inserting buffer layer, so that the prepared flexible organic electroluminescent device has a good bending endurance performance, a stable luminous property and a high light emitting efficiency.

Further description of the present invention will be illustrated, which combined with preferred embodiments and the drawings.

### Example 1

A flexible organic electroluminescent device, having layered structure as follows:

PET/ UV glue/ ZnS/ Ag/ MoO₃/ m-MTDATA/ NPB/ Ir(ppy)₃:CBP/ TPBi/ LiF/ Mg-Ag.

The method for manufacturing the flexible electroluminescent device, comprising:
firstly, PEN film having a thickness of 0.1mm was placed into deionized water containing detergent for ultrasonic cleaning, washed with deionized water, after that, ultrasonically treated successively with isopropanol and acetone, then blow dried with nitrogen;
then, the PEN film was placed on a spin coater, after starting the spin coater at a rotate speed of 1000r/min, a layer of UV glue having a thickness of 0.5µm was spin-coated on the PEN film as a flat layer, after 120s, a UV lamp was employed to cure to form a buffer layer;
subsequently, in the coating system in a vacuum degree of 5 × 10⁻⁴Pa, ZnS layer having a thickness of 35nm, Ag layer having a thickness of 18nm, MoO₃ layer having a thickness of 10nm were vapor deposited successively on the surface of buffer layer to form an anode layer;
finally, hole-injecting layer, hole-transporting layer, light-emitting layer, electron-transporting layer, electron-injecting layer and cathode layer were vapor deposited successively on MoO₃ layer, their thicknesses were, in order, 35mm, 30mm, 40mm, 20mm, 0.5mm and 150mm.

### Example 2

A flexible organic electroluminescent device, having layered structure as follows: PET / UV glue / ZnS / Ag/ MoO₃ / CuPc / TPD / DCJTB:Alq₃ / Bphen / CsF/Ag.

The method for manufacturing the flexible electroluminescent device, comprising:
firstly, PET film having a thickness of 0.175 mm was placed into deionized water containing detergent for ultrasonic cleaning, washed with deionized water, after that, ultrasonically treated successively with isopropanol and acetone, then blow dried with nitrogen;
then, the PET film was placed on a spin coater, after starting the spin coater at a rotate speed of 5000r/min, a layer of UV glue having a thickness of 5µm was spin-coated on the PEN film as a flat layer, after 30s, a UV lamp was employed to cure to form a buffer layer;
subsequently, in the coating system in a vacuum degree of 5 × 10⁻⁴Pa, ZnS layer having a thickness of 45nm, Ag layer having a thickness of 20nm, MoO₃ layer having a thickness of 5nm were vapor deposited successively on the surface of buffer layer to form an anode layer;
finally, hole-injecting layer (CuPc), hole-transporting layer (TPD), light-emitting layer (DCJTB:Alq₃), electron-transporting layer (Bphen), electron-injecting layer (CsF) and cathode layer (Ag) were vapor deposited successively on MoO₃ layer, their thicknesses were, in order, 30mm, 80mm, 15mm, 60mm, 1mm and 100mm.

### Example 3

A flexible organic electroluminescent device, having layered structure as follows: PES /UV glue/ ZnS/ Ag/ MoO₃/m-MTDATA/ TDAPB / α-NPD:Ir(MDQ)₂(acac)/ Alq₃/ LiF/ Al.

The method for manufacturing the flexible electroluminescent device, comprising:
firstly, PES film having a thickness of 0.2 mm was placed into deionized water containing detergent for ultrasonic cleaning, washed with deionized water, after that, ultrasonically treated successively with isopropanol and acetone, then blow dried with nitrogen;
then, the PES film was placed on a spin coater, after starting the spin coater at a rotate speed of 4000r/min, a layer of UV glue having a thickness of 1 µm was spin-coated on the PEN film as a flat layer, after 70s, a UV lamp was employed to cure to form a buffer layer;
subsequently, in the coating system in a vacuum degree of 5 × 10⁻⁴Pa, ZnS layer having a thickness of 80nm, Ag layer having a thickness of 30nm, MoO₃ layer having a thickness of 3nm were vapor deposited successively on the surface of buffer layer to form an anode layer;
finally, hole-injecting layer (m-MTDATA), hole-transporting layer (TDAPB), light-emitting layer (α-NPD:Ir(MDQ)₂(acac)), electron-transporting layer (Alq₃), electron-injecting layer (LiF) and cathode layer (Al) were vapor deposited successively on MoO₃ layer, their thicknesses were, in order, 40mm, 60mm, 40mm, 40mm, 2mm and 200mm.

### Example 4

A flexible organic electroluminescent device, having layered structure as follows: COC/ UV glue / ZnS/ Ag/MoO₃/m-MTDATA/NPB/Ir(ppy)₃:CBP/ PBD /LiF/Mg-Ag.

The method for manufacturing the flexible electroluminescent device, comprising:
firstly, COC film having a thickness of 0.5 mm was placed into deionized water containing detergent for ultrasonic cleaning, washed with deionized water, after that, ultrasonically treated successively with isopropanol and acetone, then blow dried with nitrogen;
then, the COC film was placed on a spin coater, after starting the spin coater at a rotate speed of 3000r/min, a layer of UV glue having a thickness of 10µm was spin-coated on the PEN film as a flat layer, after 80s, a UV lamp was employed to cure to form a buffer layer;
subsequently, in the coating system in a vacuum degree of 5 × 10⁻⁴Pa, ZnS layer having a thickness of 60nm, Ag layer having a thickness of 25nm, MoO₃ layer having a thickness of 6nm were vapor deposited successively on its surface to form an anode layer;
finally, hole-injecting layer (m-MTDATA), hole-transporting layer (NPB), light-emitting layer (Ir(ppy)₃:CBP), electron-transporting layer (PBD), electron-injecting layer (LiF) and cathode layer (Al) were vapor deposited successively on MoO₃ layer, their thicknesses were, in order, 38mm, 70mm, 25mm, 50mm, 1.5mm and 120mm.

### Example 5

A flexible organic electroluminescent device, having layered structure as follows: PC/ UV glue/ ZnS/Ag/MoO₃/m-MTDATA/NPB/Ir(ppy)₃:CBP/ TAZ/LiF/ Mg-Ag.

The method for manufacturing the flexible electroluminescent device, comprising:
firstly, PC film having a thickness of 0.4 mm was placed into deionized water containing detergent for ultrasonic cleaning, washed with deionized water, after that, ultrasonically treated successively with isopropanol and acetone, then blow dried with nitrogen;
then, the PC film was placed on a spin coater, after starting the spin coater at a rotate speed of 2000r/min, a layer of UV glue having a thickness of 7µm was spin-coated on the PEN film as a flat layer, after 50s, a UV lamp was employed to cure to form a buffer layer;
subsequently, in the coating system in a vacuum degree of 5 × 10⁻⁴Pa, ZnS layer having a thickness of 70nm, Ag layer having a thickness of 20nm, MoO₃ layer having a thickness of 8nm were vapor deposited successively on the surface of buffer layer;
finally, hole-injecting layer (m-MTDATA), hole-transporting layer (NPB), light-emitting layer (Ir(ppy)₃:CBP), electron-transporting layer (TAZ), electron-injecting layer (LiF) and cathode layer (Al) were vapor deposited successively on MoO₃ layer, their thicknesses were, in order, 30mm, 50mm, 25mm, 30mm, 1.5mm and 180mm.

### Example 6

A flexible organic electroluminescent device, having layered structure as follows:
PE/UVglue/ZnS/Ag/MoO₃/m-MTDATA/NPB/α-NPD:Ir(MDQ)₂(acac) / TPBi / LiF / Mg-Ag.

The method for manufacturing the flexible electroluminescent device, comprising:
firstly, PE film having a thickness of 0.3 mm was placed into deionized water containing detergent for ultrasonic cleaning, washed with deionized water, after that, ultrasonically treated successively with isopropanol and acetone, then blow dried with nitrogen;
then, the PE film was placed on a spin coater, after starting the spin coater at a rotate speed of 4000r/min, a layer of UV glue having a thickness of 3µm was spin-coated on the PEN film as a flat layer, after 100s, a UV lamp was employed to cure to form a buffer layer;
subsequently, in the coating system in a vacuum degree of 5 × 10⁻⁴Pa, ZnS layer having a thickness of 45nm, Ag layer having a thickness of 22nm, MoO₃ layer having a thickness of 4nm were vapor deposited successively on the surface of buffer layer;
finally, hole-injecting layer (m-MTDATA), hole-transporting layer (NPB), light-emitting layer (α-NPD:Ir(MDQ)₂(acac)), electron-transporting layer (TAZ), electron-injecting layer (LiF) and cathode layer (Al) were vapor deposited successively on MoO₃ layer, their thicknesses were, in order, 30mm, 50mm, 25mm, 30mm, 1.5mm and 180mm.

### Comparative Example 1

An organic electroluminescent device, having layered structure as follows: PET/ ITO/m-MTDATA/NPB/Ir(ppy)₃:CBP/TPBi/LiF/Mg-Ag; wherein, the device was not provided with buffer layer, and the anode layer was ITO (indium tin oxide) conductive layer, other functional layers were the same as Example 2.

The method for manufacturing the electroluminescent device, comprising:
firstly, PET film having a thickness of 0.175 mm was placed into deionized water containing detergent for ultrasonic cleaning, washed with deionized water, after that, ultrasonically treated successively with isopropanol and acetone, then blow dried with nitrogen. By using magnetron sputtering system, an ITO (indium tin oxide) conductive thin film having a thickness of 120 nm was sputtered on the surface of PET film. Then in the coating system in a vacuum degree of 5× 10⁻⁴Pa, hole-injecting layer (m-MTDATA), hole-transporting layer (NPB), light-emitting layer (Ir(ppy)₃:CBP), electron-transporting layer (TPBi), electron-injecting layer (LiF) and cathode layer (Mg-Ag) were vapor deposited successively on its surface.

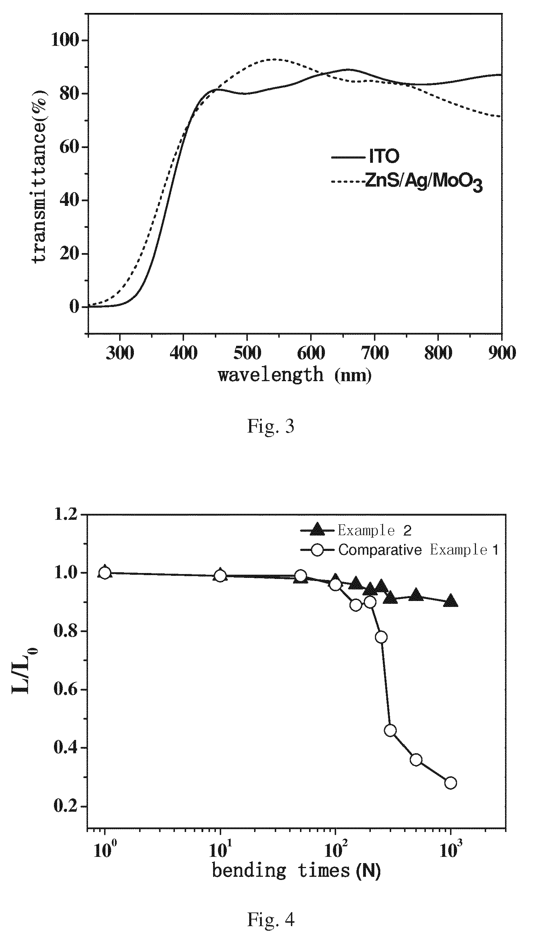

It can be seen from Fig. 3 that ZnS/Ag/MoO₃ anode prepared in Example 2 has good transmittance. The anode prepared in Example 2 has a visible transmittance of 83.8%, whereas visible transmittance of the ITO anode prepared in Comparative Example 1 is 84.2%, the two values are very close.

It can be seen from Fig. 4 that ZnS/Ag/MoO₃ anode prepared in Example 2 displays strong bonding with substrate. After bending repeatedly, luminous property remains stable, whereas ITO anode is prone to fall off the substrate, resulting in luminous property degradation.

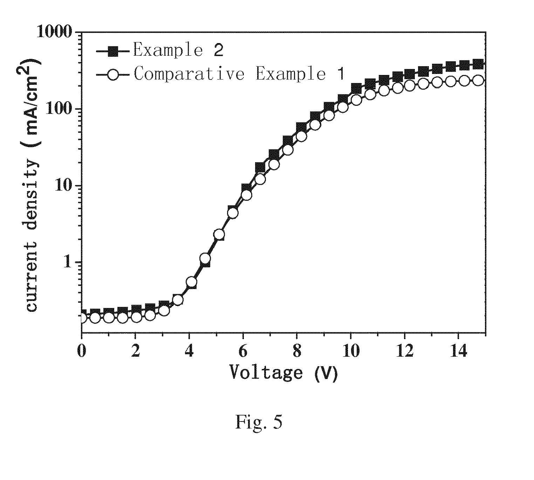

It can be seen from Fig. 5 that ZnS/Ag/MoO₃ anode prepared in Example 2 has good hole-injecting ability. Carrier injecting performance of the prepared device is similar to the device having ITO as anode, thus better electroluminescence can be obtained.

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Such alternate embodiments are considered to be encompassed within the spirit and scope of the present invention. Accordingly, the scope of the present invention is described by the appended claims and is supported by the foregoing description.

## Claims

1. A flexible organic electroluminescent device, having layered structure as follows: substrate / anode layer / hole-injecting layer / hole-transporting layer / light-emitting layer / electron-transporting layer / electron-injecting layer / cathode layer; wherein a buffer layer between said substrate and anode layer is also prepared; said anode layer has a multilayer composite structure as follows: ZnS/Ag/MoO₃.

2. The flexible organic electroluminescent device according to claim 1, wherein the material of said substrate includes any one compound selected from the group consisting of polyethylene terephthalate, polyether sulfone, polyethylene naphthalate, transparent polyimide, clyclic olefin copolymer, polycarbonate and polyethylene; thickness of said substrate is in the range of 0.1 to 0.5mm.

3. The flexible organic electroluminescent device according to claim 1, wherein in said anode layer, thickness of ZnS layer is in the range of 35 to 80nm, thickness of Ag layer is in the range of 18 to 30nm, thickness of MoO₃ layer is in the range of 3 to 10nm.

4. The flexible organic electroluminescent device according to claim 1, wherein said buffer layer is made of UV glue, the thickness of said buffer layer is in the range of 0.5 to 10µm.

5. The flexible organic electroluminescent device according to claim 1, wherein the material of said hole-injecting layer is copper phthalocyanine or 4,4',4'-tris(N-3-methylphenyl-N-phenyl-amino)-triphenylamine, thickness of said hole-injecting layer is in the range of 30 to 40nm;
the material of said hole-transporting layer is phenylmorpholine, N,N'-bis(3-methylphenyl)-N,N'-diphenyl-4,4'-benzidine (TPD) or 1,3,5-triphenylbenzene, the thickness of said hole-transporting layer is in the range of 30 to 80nm;
the material of said light-emitting layer is 4,4'-bis(N-carbazolyl)-1,1'-biphenyl doped with tris(2-phenylpyridine)iridium, the thickness of said light-emitting layer is in the range of 15 to 40nm;
the material of said electron-transporting layer is 4,7-diphenyl-1,10-phenanthroline, tris(8-hydroxyquinolinato)aluminium, 2-(4-tert-butylphenyl)-5-(4-biphenyl)-1,3,4-oxadiazole, 1,2,4-triazole derivatives or N-phenyl benzimidazole, the thickness of said electron-transporting layer is in the range of 20 to 60nm;
the material of said electron-injecting layer is LiF, CsF or 8-hydroxyquinolinato lithium, the thickness of said electron-injecting layer is 1nm;
the material of said cathode layer is Al, Ag or Mg-Ag alloy layer, the thickness of said cathode layer is in the range of 100 to 200nm.

6. A method for manufacturing flexible organic electroluminescent device, comprising:
firstly, washing and drying substrate;
then, preparing a buffer layer on the surface of the substrate;
subsequently, vapor depositing successively ZnS layer, Ag layer and MoO₃ layer on the surface of said buffer layer, forming an anode layer;
finally, vapor depositing successively hole-injecting layer, hole-transporting layer, light-emitting layer, electron-transporting layer, electron-injecting layer and cathode layer on the surface of said anode layer, obtaining flexible organic electroluminescent device.

7. The manufacturing method according to claim 6, wherein the material of said substrate includes any one compound selected from the group consisting of polyethylene terephthalate, polyether sulfone, polyethylene naphthalate, transparent polyimide, clyclic olefin copolymer, polycarbonate and polyethylene; thickness of said substrate is in the range of 0.1 to 0.5mm.

8. The manufacturing method according to claim 6, wherein in said anode layer, thickness of ZnS layer is in the range of 35 to 80nm, thickness of Ag layer is in the range of 18 to 30nm, thickness of MoO₃ layer is in the range of 3 to 10nm.

9. The manufacturing method according to claim 6, wherein said buffer layer is made of UV glue, the process for manufacturing said UV glue comprises: placing substrate on a spin coater, spin-coating UV glue on the surface of substrate, the thickness is in the range of 0.5 to 10µm, then curing using a UV lamp.

10. The manufacturing method according to claim 6, wherein the material of said hole-injecting layer is copper phthalocyanine or 4,4',4'-tris(N-3-methylphenyl-N-phenyl-amino)-triphenylamine, thickness of said hole-injecting layer is in the range of 30 to 40nm;
the material of said hole-transporting layer is phenylmorpholine, N,N'-bis(3-methylphenyl)-N,N'-diphenyl-4,4'-benzidine (TPD) or 1,3,5-triphenylbenzene, the thickness of said hole-transporting layer is in the range of 30 to 80nm;
the material of said light-emitting layer is 4,4'-bis(N-carbazolyl)-1,1'-biphenyl doped with tris(2-phenylpyridine)iridium, the thickness of said light-emitting layer is in the range of 15 to 40nm;
the material of said electron-transporting layer is 4,7-diphenyl-1,10-phenanthroline, tris(8-hydroxyquinolinato)aluminium, 2-(4-tert-butylphenyl)-5-(4-biphenyl)-1,3,4-oxadiazole, 1,2,4-triazole derivatives or N-phenyl benzimidazole, the thickness of said electron-transporting layer is in the range of 20 to 60nm;
the material of said electron-injecting layer is LiF, CsF or 8-hydroxyquinolinato lithium, the thickness of said electron-injecting layer is 1nm;
the material of said cathode layer is Al, Ag or Mg-Ag alloy layer, the thickness of said cathode layer is in the range of 100 to 200nm.
